## Europäisches Patentamt

## European Patent Office

## Office européen des brevets

(19)

(11) Veröffentlichungsnummer: **0 108 261**
**B1**

(12) # EUROPÄISCHE PATENTSCHRIFT

(45) Veröffentlichungstag der Patentschrift:
**01.06.88**

(21) Anmeldenummer: **83109989.0**

(22) Anmeldetag: **06.10.83**

(51) Int. Cl.⁴: **G 06 F 11/22**, G 06 F 11/30,
G 06 F 11/34

(54) **Logikanalysator.**

(30) Priorität: **05.11.82 DE 3240926**

(43) Veröffentlichungstag der Anmeldung:
**16.05.84 Patentblatt 84/20**

(45) Bekanntmachung des Hinweises auf die Patenterteilung:
**01.06.88 Patentblatt 88/22**

(84) Benannte Vertragsstaaten:
**DE FR GB NL**

(56) Entgegenhaltungen:
**DE - A - 2 831 726**

**ELECTRONIC DESIGN, Band 30, Nr. 20, September 1982, Seiten 133-139, Waseca, MN, Denville, NJ, US; P. DEVERSON: "Menus and soft keys simplify setup of logic analyzer"**
**ELEKTRONIK, Band 31, Nr. 3, Februar 1982, Seiten 45-50, München, DE; W. KLUG: "Datenselektion in der Logikanalyse"**

(73) Patentinhaber: **Rohde & Schwarz GmbH & Co. KG,
Mühldorfstrasse 15, D-8000 München 80 (DE)**

(72) Erfinder: **Frühauf, Tonio, Fasanenstrasse 68,
D-8025 Unterhaching (DE)**
Erfinder: **Schubert, Wolfgang, Hofangerstrasse 65,
D-8000 München 83 (DE)**

(74) Vertreter: **Graf, Walter, Dipl.-Ing., Sckellstrasse 1,
D-8000 München 80 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft einen Logikanalysator laut Oberbegriff des Hauptanspruches.

Logikanalysatoren dieser Art sind bekannt (Elektronik 3/12.2.82, S. 45–50 bzw. Logikanalysator IMA der Firma Rohde & Schwarz). Sie ermöglichen die Auswertung und Analyse von beliebigen digitalen Funktionsabläufen, die als binär codierte Signale dem Analysatoreingang zugeführt werden. Mit einem solchen Logikanalysator können beispielsweise die Programmabläufe, d.h. die Aufeinanderfolge von Datenworten eines Mikroprozessors analysiert werden oder Untersuchungen an Bussystemen und allgemeinen Logikschaltungen durchgeführt werden. Die binär codierten Datenwortfolgen werden dabei nacheinander in den Analysatorspeicher eingelesen und dieser Speicherinhalt kann anschliessend durch eine geeignete Auswerteinrichtung analysiert und beispielsweise auf einem Bildschirm in beliebiger Codierung dargestellt werden. Da der Analysatorspeicher nur eine endliche Speicherkapazität hat und beispielsweise nur 250 Datenworte speichern kann, werden nicht alle Datenworte der zu analysierenden Datenwortfolge in den Speicher eingelesen, sondern über die zusätzlich noch vorgesehene Datenqualifizierungseinrichtung werden diejenigen Datenworte selektiert, die vom Benutzer als analysierenswert bestimmt werden. Die tatsächlich in den Analysatorspeicher eingelesenen Daten werden also auf die tatsächlich zu analysierenden Daten reduziert und so der Analysatorspeicher wirksamer genutzt.

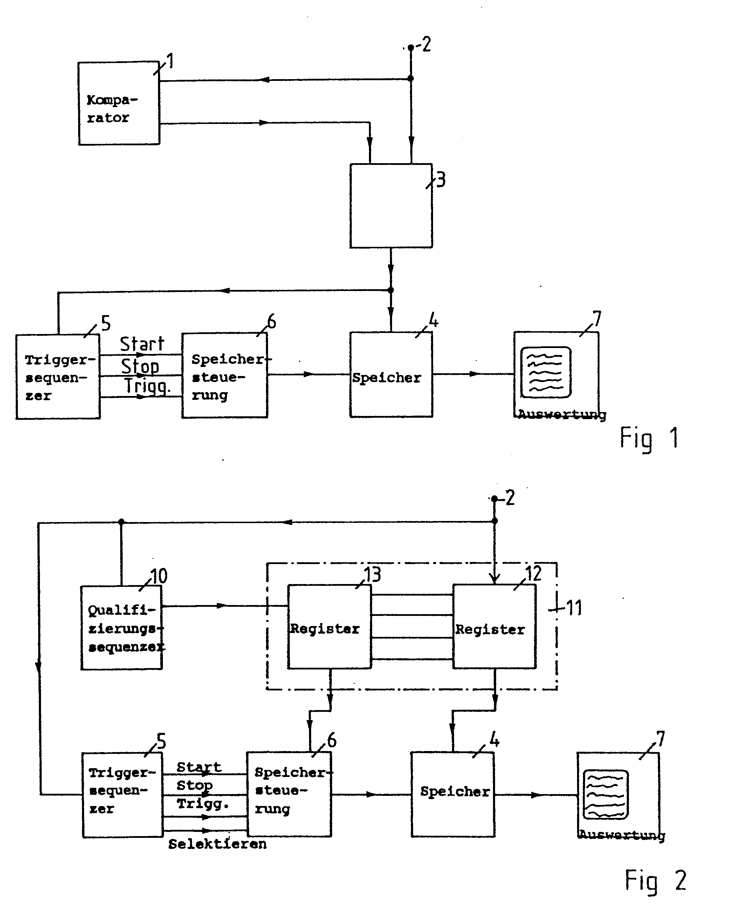

Fig. 1 zeigt das Prinzipschaltbild eines bekannten Logikanalysators der eingangs erwähnten Art. Die Datenqualifizierungseinrichtung ist hierbei ein Komparator 1, der jedes einzelne am Eingang 2 eingelesene Datenwort mit einem in den Komparator 1 eingegebenen vorbestimmten Selektionskriterium vergleicht. Wenn ein ankommendes Datenwort mit den Daten des vorbestimmten Selektionskriteriums übereinstimmt wird über eine Und-Schaltung 3 das so selektierte Datenwort in den Analysatorspeicher 4 eingelesen und dort gespeichert.

Es ist auch schon bekannt, einen solchen Komparator mit einem Pufferregister auszustatten und so auszubilden, dass ein vorbestimmtes Datenmuster in zwei aufeinanderfolgenden Worten als Selektionskriterium erkannt und abgespeichert werden kann (Electronic Design, Bd. 30, No. 20, September 1982, S. 133–139, Waseca, MN, Denville, NJ, USA; P. Deverson: «Menues and soft keys simplify setup of logic analyzer»).

Im obengenannten Stand der Technik ist zur Erhöhung der Datenselektion und damit zur weiteren Verbesserung der Effektivität des Analysatorspeichers eine als sogenannte Sequenzerschaltung ausgebildete Triggereinrichtung 5 vorgesehen, welche die selektierten Datenworte auswertet. Eine Triggersequenzerschaltung als solche ist auch beschrieben in DE-A 2 831 726. Diese Triggersequenzeinrichtung arbeitet in mehreren Entscheidungsebenen und sie kann so programmiert werden, dass die Triggerung des Speichers 4 über die zwischengeschaltete Speichersteuerschaltung 6 immer dann ausgelöst wird, wenn mehrere aufeinanderfolgende Datenworte ein bestimmtes Triggerkriterium erfüllen.

An dieser Triggersequenzerschaltung 5 kann nicht nur ein Triggerkriterium für den Speicher 4 eingestellt werden, sondern es kann hier auch ein aus mehreren aufeinanderfolgenden Datenworten zusammengesetztes Selektionskriterium eingestellt werden. Wenn dieses vorprogrammierte Selektionskriterium erfüllt ist, wird ein entsprechender Startbefehl an die Speichersteuerschaltung 6 gegeben. Tritt ein vorbestimmtes anderes eingegebenes Selektionskriterium auf, wird der Speichervorgang wieder gestoppt. Eine so auf Selektion programmierte Triggersequenzerschaltung hat also die Wirkung eines zusätzlichen Selektionskriteriums und hierdurch kann die Selektionsschärfe eines Analysators erhöht werden. Diese Art der Selektionsschärfenerhöhung über die Triggereinrichtung hat jedoch den Nachteil, dass nicht gleichzeitig neben dem sich wiederholenden komplexen Selektionskriterium auch ein komplexes Triggerkriterium in die Triggereinrichtung eingegeben werden kann, ohne dass der Aufwand für die Triggereinrichtung unverhältnismässig hoch wird. Das Selektionskriterium ausgedehnt auf mehrere aufeinanderfolgende Datenworte muss nämlich ständig wirksam sein und muss daher in jeder Triggerentscheidungsebene neu definiert werden, da ja während des Abarbeitens der einzelnen aufeinanderfolgenden Triggerentscheidungsebenen der Selektionsvorgang ständig erhalten bleiben muss. Es muss also das Selektionskriterium auf jeder Triggerebene neu abgebildet werden, was eine Multiplikation der erforderlichen Entscheidungsebenen der Triggereinrichtung bedeutet. Sollen beispielsweise drei aufeinanderfolgende Datenworte als Selektionskriterium ausgewertet werden und soll beispielsweise das Triggerkriterium vier aufeinanderfolgende Datenworte berücksichtigen, so müsste die Triggereinrichtung für die Berücksichtigung dieses Selektionskriteriums und Triggerkriteriums zwölf aufeinanderfolgende Entscheidungsebenen aufweisen.

Diese Möglichkeit der Ausnutzung der Triggereinrichtung zur Erhöhung der Selektionsschärfe über die Start-Stop-Steuerung des Speichers in Abhängigkeit von in die Triggereinrichtung eingegebenen vorbestimmten Datenwortfolgen ist natürlich nur brauchbar für die Selektion von solchen Daten, die zeitlich nach diesem Selektionskriterium auftreten. In vielen Anwendungsfällen ist es jedoch nötig, auch solche Datenworte abzuspeichern und anschliessend zu analysieren, die innerhalb des Selektionskriteriums liegen, dieses also mitbestimmen, oder die sogar vor den das Selektionskriterium bildenden Datenworten in den Analysator eingelesen wurden.

Es ist daher Aufgabe der Erfindung, einen Logikanalysator zu schaffen, der bei geringst möglichem schaltungstechnischen Aufwand eine verbesserte und gezieltere Selektion vorbestimmter Datenworte ermöglicht und bei dem ausserdem auch solche Datenworte abgespeichert werden können, die nicht nur nach dem Selektionskriterium auftreten, sondern vor oder innerhalb dieses Selektionskriteriums auftreten.

Diese Aufgabe wird ausgehend von einem Logikanalysator laut Oberbegriff des Hauptanspruches durch dessen kennzeichnende Merkmale gelöst. Vorteilhafte Weiterbildungen ergeben sich aus den Unteransprüchen.

Beim erfindungsgemässen Logikanalysator wird also anstelle eines nur in einer Ebene arbeitenden Selektions-Komparators eine sequentiell arbeitende an sich bekannte Sequenzerschaltung als Datenqualifizierungseinrichtung benutzt, die es in bekannter Weise ermöglicht, eine Folge von mehreren aufeinanderfolgenden Datenworten nacheinander zu betrachten und auszuwerten und erst dann zu entscheiden, ob diese Datenwortfolge das vorgegebene Selektionskriterium erfüllt oder nicht. Die hierfür vorgesehene Sequenzerschaltung entspricht im schaltungstechnischen Aufbau der obenerwähnten Triggereinrichtung, die es ebenfalls schon ermöglicht, mehrere aufeinanderfolgende Datenworte für eine bestimmte Entscheidung zu berücksichtigen. Da diese zur Qualifizierung benutzte zusätzliche Sequenzerschaltung unabhängig von der Triggereinrichtung arbeitet wird der schaltungstechnische Aufwand gegenüber der obenerwähnten bekannten Lösung wesentlich reduziert, da zusätzlich zu der Anzahl von Triggerentscheidungsebenen nur die für die Qualifizierung nötigen zusätzlichen Entscheidungsebenen der Sequenzerschaltung hinzukommen und die Anzahl der Entscheidungsebenen nicht multipliziert werden muss. Durch den zusätzlich noch vorgesehenen Zwischenspeicher können nicht nur Datenworte abgespeichert werden, die das Selektionskriterium erfüllen und zeitlich nach diesem eingelesen werden, sondern es können auch solche Datenworte abgespeichert werden, die unmittelbar innerhalb dieses Selektionskriteriums auftreten und beispielsweise dieses mitbestimmen oder die sogar vorher schon eingelesen wurden, da diese Datenworte ja in dem Zwischenspeicher weiterhin zur Verfügung stehen. Ein erfindungsgemässer Logikanalysator ist daher wesentlich universeller einsetzbar und es können mit ihm auch Mikroprozessorprogramme analysiert werden, wobei eine beliebige Selektion beispielsweise nach Befehlsart, Adresse oder Dateninhalt des Programms möglich ist.

Die Erfindung wird im folgenden anhand der Fig. 2 an einem Ausführungsbeispiel näher erläutert.

Gemäss der Erfindung dient als Datenqualifizierungseinrichtung eine Sequenzerschaltung 10, der eingangsseitig die am Eingang eingelesenen aufeinanderfolgenden Datenworte eingegeben werden. Vor dem eigentlichen Analysatorspeicher 4 ist noch ein zusätzlicher Zwischenspeicher 11 angeordnet, dem eingangsseitig ebenfalls die eingelesenen Datenwortfolgen zugeführt werden. Dieser Zwischenspeicher 11 ist über die Sequenzerschaltung 10 steuerbar.

In dem gezeigten Ausführungsbeispiel besteht der Zwischenspeicher 11 aus zwei parallel geschalteten Schieberegistern 12 und 13. In das eine Schieberegister 12, das zwischen Eingang 2 und Speicher 4 angeordnet ist, werden die ankommenden aufeinanderfolgenden Datenworte nacheinander eingelesen. Sie stehen damit für einen Zeitraum zur Verfügung, der durch die Länge dieses Schieberegisters 12 bestimmt ist. Die Länge dieses Schieberegisters sollte mindestens so gross sein, dass sämtliche Datenworte darinnen gespeichert werden können, die auch in der Sequenzerschaltung 10 zur Bestimmung des Selektionskriteriums benutzt werden. Vorzugsweise wird der Umfang dieses Schieberegisters 12 sogar noch grösser gewählt, um mit Sicherheit auch noch Datenworte qualifizieren zu können, die vor dem Selektionskriterium eingelesen wurden. Das Schieberegister 13 besitzt den gleichen Speicherumfang. Die Sequenzerschaltung 10 wird vom Benutzer auf ausgewählte aufeinanderfolgende Datenworte programmiert. Wenn in der am Eingang 2 eingelesenen Datenwortfolge diese vorbestimmte und das Selektionskriterium bildende Datenwortfolge über die Sequenzerschaltung 10 festgestellt wird, wenn also das Selektionskriterium erfüllt ist, werden in das Schieberegister 13 parallel an allen Speicherstellen Markierungsinformationen eingeschrieben, die festlegen, wo im parallel dazu geschalteten Schieberegister 12 die als selektionswürdig erkannten Datenworte stehen. Auf diese Weise werden also im Zwischenspeicher 11 diejenigen Datenworte entsprechend markiert, die definitionsgemäss selektiert und in den Speicher 4 für die spätere Auswertung in der Auswerteinrichtung 7 eingelesen werden sollen. Alle anderen Daten im Zwischenspeicher 11 werden damit zwangsläufig so markiert, dass sie nicht in den Speicher 4 eingelesen werden sollen. Dies geschieht durch entsprechende Ansteuerung der Speichersteuereinrichtung 6 durch das damit verbundene Schieberegister 13. Nur wenn am Ausgang des Schieberegisters 13 eine Markierungsinformation erscheint (als Kennzeichen für ein abzuspeicherndes Datenwort) wird auch das gleichzeitig am Ausgang des Schieberegisters 12 erscheinende Datenwort in den Speicher 4 eingelesen.

Die Triggereinrichtung 5 ist ausserdem über die Steuerleitungen «Start»/«Stopp» und «Triggern»/ «Selektieren» mit der Speichersteuereinrichtung 6 verbunden. Damit ist es möglich, abhängig von der Triggereinrichtung die Selektionsfunktion ein- und auszuschalten, es kann also in Abhängigkeit von den Triggersequenzereignissen selbsttätig entschieden werden, ob die ankommenden Datenworte ohne Selektion alle in den Speicher 4 eingelesen werden sollen oder ob die Selektionseinrichtung wirksam sein soll und nur die über die Sequenzerschaltung 10 selektierten Datenworte eingelesen werden sollen.

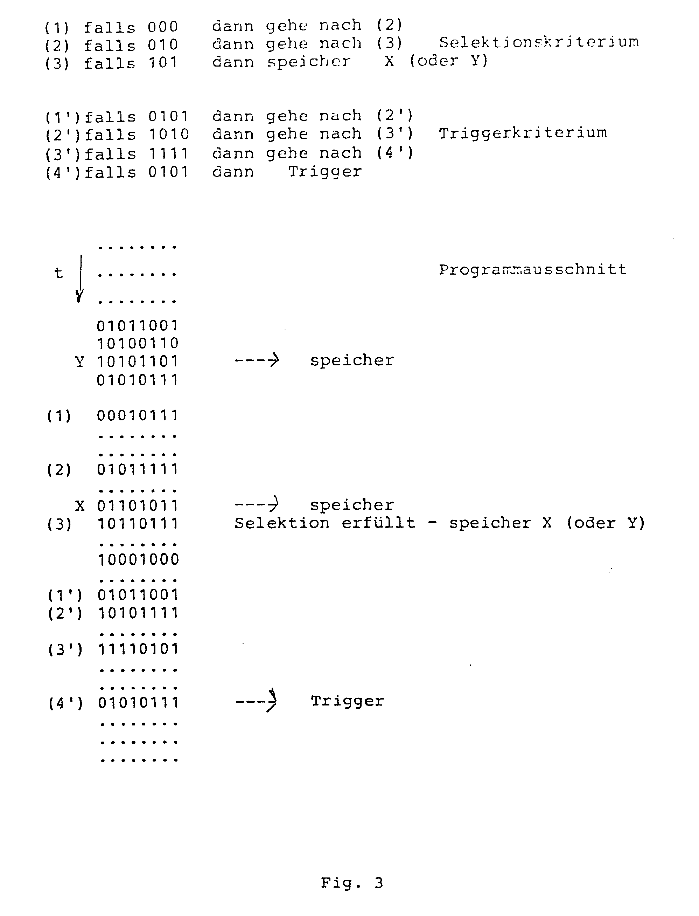

Fig. 3 zeigt anhand eines Programmausschnittes die Arbeitsweise eines erfindungsgemässen Logikanalysators, und zwar am Beispiel von binär codierten 8-stelligen aufeinanderfolgenden Da-

tenworten. In Fig. 3 ist angenommen, dass das Selektionskriterium erfüllt ist, wenn in drei aufeinanderfolgenden Datenworten die jeweils ersten drei Stellen die angegebene Reihenfolge aufweisen. In dem Ausführungsbeispiel ist ferner angenommen, dass bei Erfüllung dieses Selektionskriteriums beispielsweise das Datenwort X im Speicher 4 abgespeichert werden soll, das unmittelbar dem letzten Datenwort 3 aus ausgewählten Selektionskriteriums vorhergeht. In Fig. 3 ist als zweites Beispiel ferner noch angegeben, wie bei Erfüllung dieses vorbestimmten Selektionskriteriums ein mehrere Stellen vorhergehendes Datenwort Y abgespeichert werden soll, das im Zwischenspeicher 11 noch zur Verfügung steht. Der Benutzer programmiert also die Sequenzerschaltung 10 entsprechend dem in Fig. 3 angegebenen Selektionskriterium und wenn dieses Selektionskriterium erfüllt ist, wird im Schieberegister 13 derjenige Speicherplatz markiert, an welchem parallel dazu im Schieberegister 12 das laut Programm abzuspeichernde Datenwort X oder Y gespeichert ist. Nach diesem Schema können also alle das Selektionskriterium erfüllende Datenworte nacheinander im Zwischenspeicher 11 gespeichert und von dort dann die entsprechend markierten Datenworte in den eigentlichen Analysatorspeicher 4 eingelesen werden. In entsprechender Weise kann der Benutzer an der Triggersequenzerschaltung 5 das Triggerkriterium einstellen. Wenn die Datenfolge des angenommenen Triggerkriteriums erfüllt ist, wird der Speicher 4 getriggert und es stehen dann alle bis zu diesem Zeitpunkt in den Speicher 4 eingelesenen Datenworte zur Auswertung in der Auswerteinrichtung 7 zur Verfügung. Der zusätzliche Zwischenspeicher 11 ermöglicht es bei entsprechendem Umfang seiner Schieberegister 12, 13, dass bei Erfüllung des Selektionskriteriums auch ein Datenwort abgespeichert werden kann, das mehrere Ebenen vor oder nach diesem Selektionskriterium eingelesen wurde, also beispielsweise das mehrere Ebenen vor Erfüllung des Selektionskriteriums eingelesene Datenwort Y.

**Patentansprüche**

1. Logikanalysator mit einem Analysatorspeicher (4), einer Qualifizierungseinrichtung zum Selektieren vorbestimmter zu analysierender Datenworte aus der am Analysatoreingang (2) eingelesenen Datenwortfolge und einer von dieser Qualifizierungseinrichtung unabhängig und parallel hierzu arbeitenden Triggersequenzerschaltung (5) zum Positionieren der selektierten Datenworte im Analysatorspeicher (4), dadurch gekennzeichnet, dass die Qualifizierungseinrichtung eine Sequenzerschaltung (10) ist, an welcher unabhängig vom Triggerkriterium ein aus mehreren aufeinanderfolgenden Datenworten bestehendes Selektionskriterium einstellbar ist, und vor dem Analysatorspeicher (4) ein Zwischenspeicher (11) angeordnet ist, der durch diese Qualifizierungs-Sequenzerschaltung (10) so gesteuert ist, dass sogar zeitlich vor diesem Selektionskriterium auftretende Datenworte zur Analyse in den Analysatorspeicher (4) einlesbar sind.

2. Logikanalysator nach Anspruch 1, dadurch gekennzeichnet, dass der Zwischenspeicher (11) aus zwei parallelgeschalteten Schieberegistern (12, 13) besteht, die Datenwortfolge in das erste Schieberegister (12) fortlaufend eingelesen wird und dann, wenn durch die Qualifizierungs-Sequenzerschaltung (10) die Erfüllung des vorbestimmten Selektionskriteriums festgestellt ist, in dem zweiten Schieberegister (13) diejenigen Datenworte des ersten Schieberegisters (12) markiert werden, die das Selektionskriterium erfüllen, und so die Datenworte des ersten Schieberegisters (12) in Abhängigkeit von dieser Markierungsinformation aus dem ersten Schieberegister (12) in den Analysatorspeicher (4) eingelesen werden.

3. Logikanalysator nach Anspruch 1 oder 2, dadurch gekennzeichnet, dass die Triggersequenzerschaltung (5) mit der Speichersteuereinrichtung (6) so verknüpft ist, dass die Funktionen «alles einlesen», «selektiert einlesen» und «nichts einlesen» wählbar sind.

**Claims**

1. A logic analyzer comprising an analyzer memory (4), a qualifying means for selecting predetermined data words to be analyzed from the data word sequence read in at the analyzer input (2), and a trigger sequencer circuit (5) which operates independently of said qualifying means and in parallel therewith for positioning the selected data words in the analyzer memory (4), characterized in that the qualifying means is a sequencer circuit (10) in which a selection criterion composed of plural successive data words can be set independently of the trigger criterion, and that the analyzer memory (4) is preceded by a temporary memory (11) adapted to be controlled by said qualifying sequencer circuit (10) in such a way that even data words which occur before said selection criterion in terms of time can be read into the analyzer memory (4) for analysis therein.

2. A logic analyzer as claimed in claim 1, characterized in that the temporary memory (11) is composed of two parallel-connected shift registers (12, 13), that the data word sequence is continually read into the first shift register (12) and that, when the qualifying sequencer circuit (10) decides that the predetermined selection criterion has been met, those data words of the first shift register (12) which meet the selection criterion are marked in the second shift register (13) so that the data words of the first shift register (12) are read from the first shift register (12) into the analyzer memory (4) in response to said mark information.

3. A logic analyzer as claimed in claim 1 or claim 2, characterized in that the trigger sequencer circuit (5) is coupled with the memory control unit (6) in such a way that the functions "read all", "read selectively" and "read nothing" can be chosen.

**Revendications**

1. Analyseur logique avec une mémoire d'analyseur (4), un dispositif de qualification pour sélectionner des mots de données prédéterminés à analyser, à partir de la succession de mots de données introduits à l'entrée (2) de l'analyseur, et avec un circuit séquentiel de déclenchement (5), indépendant de ce dispositif de qualification et opérant parallèlement à lui, pour positionner les mots de données sélectionnés dans la mémoire d'analyseur (4), analyseur caractérisé en ce que le dispositif de qualification est un circuit séquentiel (10), dans lequel peut être introduit indépendamment du critère de déclenchement, un critère de sélection constitué de plusieurs mots de données successifs, tandis qu'il est prévu avant la mémoire d'analyseur (4) une mémoire intermédiaire (11) qui est commandée par ce circuit séquentiel (10) de qualification de façon que même des mots de données intervenant dans le temps avant ce critère de sélection puissent être introduits pour analyse dans la mémoire d'analyseur (4).

2. Analyseur logique selon la revendication 1, caractérisé en ce que la mémoire intermédiaire (11) est constituée de deux registres à décalage branchés en parallèle (12, 13), la succession de mots de données étant introduite de façon continue dans le premier registre à décalage (12) et, lorsque par l'intermédiaire du circuit séquentiel (10) de qualification, il est constaté que le critère de sélection prédéterminé est satisfait, les mots de données du premier registre à décalage (12) qui satisfont le critère de sélection sont repérés dans le second registre à décalage (13), et ainsi les mots de données du premier registre à décalage (12) sont, en fonction de cette information de repérage, introduits dans la mémoire d'analyseur (4) à partir du premier registre à décalage (12).

3. Analyseur logique selon la revendication 1 ou 2, caractérisé en ce que le circuit séquentiel de déclenchement (5) est combiné avec le dispositif (6) de commande de la mémoire, de façon que les fonctions «tout introduire», «introduire les mots sélectionnés», et «ne rien introduire» puissent être sélectionnées.

Fig 1

Fig 2

```
(1) falls 000    dann gehe nach (2)
(2) falls 010    dann gehe nach (3)     Selektionskriterium
(3) falls 101    dann speicher   X (oder Y)


(1')falls 0101   dann gehe nach (2')
(2')falls 1010   dann gehe nach (3')    Triggerkriterium
(3')falls 1111   dann gehe nach (4')
(4')falls 0101   dann   Trigger
```

```
        . . . . . . . .
  t |   . . . . . . . .                  Programmausschnitt
    |
    V   . . . . . . . .

        01011001
        10100110
    Y   10101101         ---->   speicher
        01010111

(1)     00010111
        . . . . . . . .
        . . . . . . . .
(2)     01011111
        . . . . . . . .
    X   01101011         ---->   speicher
(3)     10110111         Selektion erfüllt - speicher X (oder Y)
        . . . . . . . .
        10001000
        . . . . . . . .
(1')    01011001
(2')    10101111
        . . . . . . . .
(3')    11110101
        . . . . . . . .
        . . . . . . . .
(4')    01010111         ---->   Trigger
        . . . . . . . .
        . . . . . . . .
        . . . . . . . .
```

Fig. 3